# EUROPÄISCHE PATENTANMELDUNG

(11) **EP 2 648 177 A2**
(43) Veröffentlichungstag der Anmeldung: **09.10.2013**
(21) Anmeldenummer: 13001666.0
(22) Anmeldetag: 28.03.2013
(51) Int. Cl.: G09F 9/302

(54) **Anzeigeeinrichtung**

(30) Priorität: 02.04.2012 DE 102012006548
(71) Anmelder: MENTOR GmbH & Co. Präzisions-Bauteile KG, 40699 Erkrath (DE)
(72) Erfinder: Schulz, Pablo, 40822 Mettmann (DE)
(74) Vertreter: Sparing Röhl Henseler

(57) **Zusammenfassung**

Anzeigeeinrichtung zum Anzeigen von Informationen mit einer Mehrzahl von lichtemittierenden Elementen (1), die zueinander benachbart auf einem Anzeigenfeld einer Leiterplatte angeordnet und individuell ansteuerbar sind, wobei den lichtemittierenden Elementen (1) jeweils ein Hohlraum (4) zur Formgebung der von den lichtemittierenden Elementen (1) ausgesendeten Lichtstrahlen zur Erzeugung jeweils einer vergrößerten effektiven Leuchtfläche (7) in einem opakem Rahmen (5) zugeordnet ist, wobei die Hohlräume (4) der lichtemittierenden Elemente (1) ein flächig angeordnetes Hohlraumgefüge (6) bilden, deren effektive Leuchtflächen (7) abgedeckt sind durch eine lichtdichte Abschlussfläche mit lichtdurchlässigen Segmentfeldern (9), die jeweils einen Teilbereich der Leuchtfläche (7) eines Hohlraums (4) des Hohlraumgefüges (6) als beleuchtbaren Leuchtflächenausschnitt bestimmen.

## Beschreibung

Die Erfindung betrifft eine Anzeigeeinrichtung zum Anzeigen von Informationen mit einer Mehrzahl von lichtemittierenden Elementen nach dem Oberbegriff des Anspruchs 1.

Aus DE 102 39 090 B4 ist eine Anzeigevorrichtung mit mehreren Lichtquellen und einem opaken Rahmen bekannt, an dessen Oberseite ein im Bereich von Leuchtflächen für das Licht der Lichtquellen durchlässiges Leuchtfeld, welches beispielsweise eine 7-Segment-Anzeige ist, vorgesehen ist. Die in zugeordneten Hohlräumen des Rahmens angeordneten Lichtquellen sind unmittelbar auf einer gedruckten Leiterplatte befestigt und elektrisch kontaktiert. Die restlichen Volumina der jeweiligen Hohlräume, in denen die Lichtquellen angeordnet sind, sind mit bis zur Leuchtfläche reichenden Diffusoren angefüllt. Eine Anpassung der Bauhöhe des Rahmens verlangt deshalb auch eine Anpassung der Diffusoren, weshalb der opake Rahmen und die Diffusoren als ein Spritzgusssteil aus thermoplastischem Kunststoff ausgebildet sind. Dies ist aufwändig.

Aus DE 197 38 972 A1 ist eine Displayanordnung zum Anzeigen von Informationen mit einer Vielzahl von lichtemittierenden Elementen bekannt, die zueinander benachbart angeordnet und individuell ansteuerbar sind. Den lichtemittierenden Elementen ist wenigstens ein Element zur Vergrößerung und/oder Formgebung der von den lichtemittierenden Elementen ausgesendeten Lichtstrahlen zugeordnet. Durch das wenigstens eine Element ergibt sich eine vergrößerte effektive Leuchtfläche der angesteuerten lichtemittierenden Elemente bzw. Leuchtpunkte. Durch das wenigstens eine Element in Form eines Reflektors in einem Rahmen wird gleichzeitig eine unerwünschte seitliche Abstrahlung der lichtemittierenden Elemente verhindert und damit die Effizienz der Abstrahlung bzw. Flächenleuchtdichte verbessert. Nachteilig ist die Formvorgabe der Leuchtpunkte durch die Reflektoren.

Aufgabe der Erfindung ist es daher, eine Anzeigeeinrichtung nach dem Oberbegriff des Anspruchs 1 zu schaffen, die eine gute Ausleuchtung von beleuchtbaren Segmentfeldern erlaubt und dabei in besonders einfacher Weise mit unterschiedlichen Bauhöhen montierbar ist.

Diese Aufgabe wird durch die Merkmale des Anspruchs 1 gelöst.

Hierdurch wird eine Anzeigeeinrichtung geschaffen, deren Rahmen in der Höhe veränderbar ist, ohne dass das Lichtleiterverhalten der Hohlräume sich auf die Beleuchtung der Segmentfelder wesentlich auswirkt. Die Segmentfelder sind nur ein Bildausschnitt der von einem Hohlraum erzeugten effektiven Leuchtfläche. Die Gleichmäßigkeit der Ausleuchtung der Segmentfelder kann hierdurch unabhängig von der Bauhöhe erreicht werden. Besonders vorteilhaft ist hierzu das Hohlraumgefüge wabenartig mit Stegen ausgebildet.

Vorzugsweise ist eine Diffusorplatte als kopfseitige Deckplatte vorgesehen, da dann im ausgeschalteten Zustand das lichtemittierende Element, insbesondere eine LED, nicht zu sehen ist.

Weitere Ausgestaltungen der Erfindung sind den Unteransprüchen und der nachfolgenden Beschreibung zu entnehmen.

Die Erfindung wird nachstehend anhand der in den beigefügten Abbildungen dargestellten Ausführungsbeispiele näher erläutert.
Fig. 1 zeigt schematisch eine Explosionsdarstellung einer Anzeigeeinrichtung mit einem Anzeigenfeld einer Leiterplatte, einem opaken Rahmen und einer Diffusorplatte,
Fig. 2 zeigt schematisch eine Unteransicht des opaken Rahmens mit lichtemittierenden Elementen der Leiterplatte,
Fig. 3 zeigt schematisch eine Draufsicht des opaken Rahmens mit lichtemittierenden Elementen der Leiterplatte und Segmentfeldern einer lichtdichten Abschlussfläche.

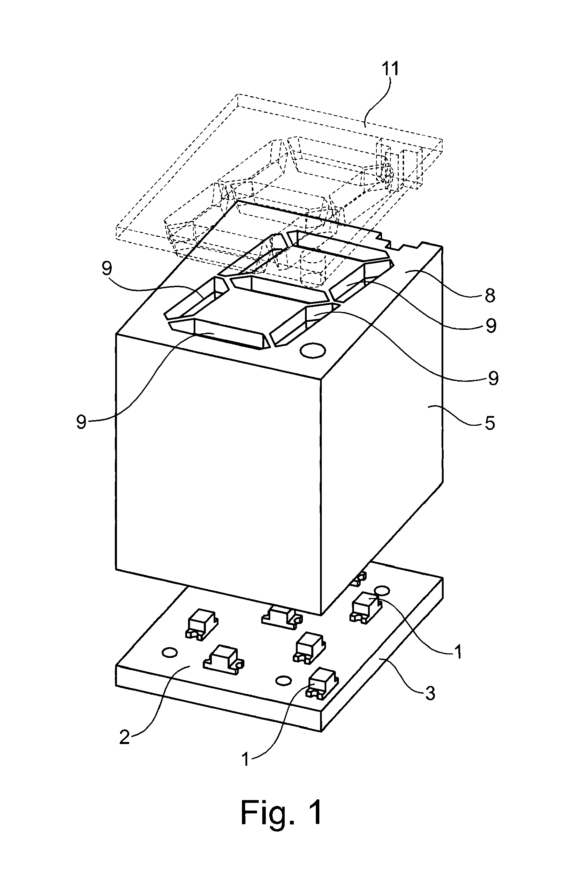

Fig. 1 zeigt eine Anzeigeeinrichtung zum Anzeigen von Informationen mit einer Mehrzahl von lichtemittierenden Elementen 1, die zueinander benachbart auf einem Anzeigenfeld 2 einer Leiterplatte 3 angeordnet und individuell ansteuerbar sind mittels einer nicht dargestellten Elektrik/Elektronik.

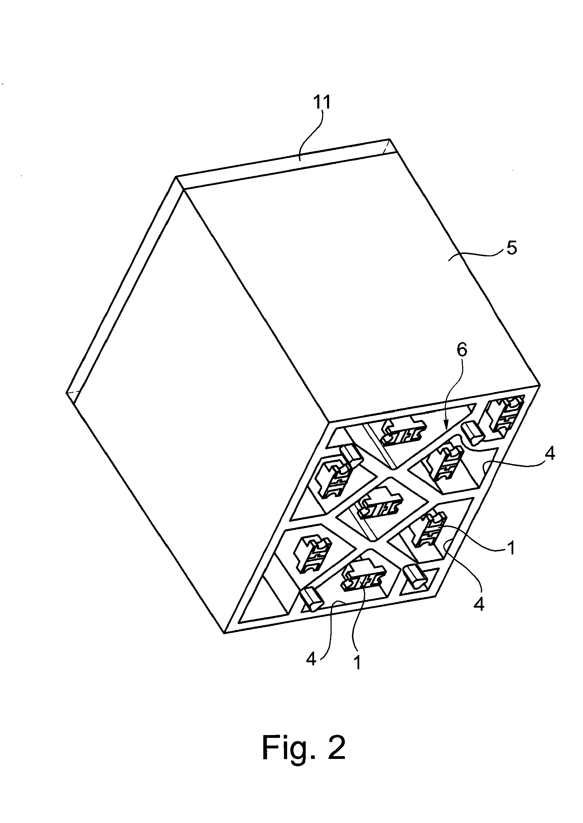

Wie Fig. 1 in Zusammenschau mit Fig. 2 zeigt, ist den lichtemittierenden Elementen 1 jeweils ein Hohlraum 4 in einem opaken Rahmen 5 zugeordnet. Die Hohlräume 4 dienen zur Formgebung der von den lichtemittierenden Elementen 1 ausgesendeten Lichtstrahlen, wodurch jeweils eine vergrößerte effektive Leuchtfläche erzeugt wird. Durch den opaken Rahmen 5 wird gleichzeitig eine unerwünschte seitliche Abstrahlung der von den lichtemittierenden Elementen 1 ausgesendeten Lichtstrahlen verhindert.

Wie insbesondere Fig. 2 zeigt, bilden die Hohlräume 4 für die lichtemittierenden Elemente 1 ein flächig angeordnetes Hohlraumgefüge 6.

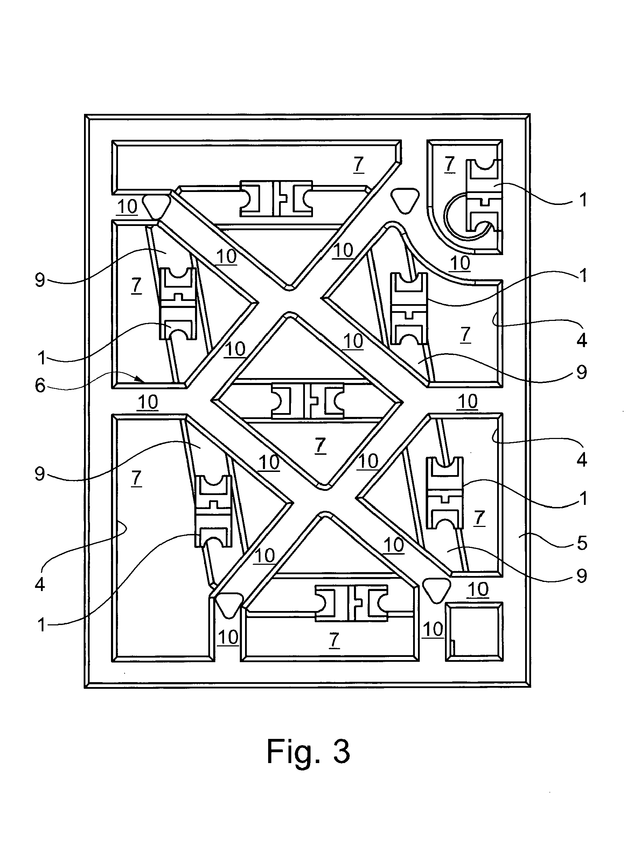

Wie Fig. 1 in Zusammenschau mit Fig. 3 zeigt, bilden die Hohlräume 4 effektive Leuchtflächen 7, die begrenzt werden durch die Begrenzungsflächen des jeweiligen Hohlraumes 4 und größer sind als die Leuchtpunktfläche der lichtemittierenden Elemente 1. Die Begrenzungsflächen des jeweiligen Hohlraums 4 sind vorzugsweise Reflektoren.

Wie Fig. 1 zeigt, sind die effektiven Leuchtflächen 7 abgedeckt durch eine lichtdichte Abschlussfläche 8 mit lichtdurchlässigen Segmentfeldern 9, die jeweils einen Teilbereich der Leuchtfläche 7 eines Hohlraums 4 des Hohlraumgefüges 6 als beleuchtbaren Leuchtflächenausschnitt bestimmen.

Wie. Fig. 1 und Fig. 2 zeigen, ist das Hohlraumgefüge 6 vorzugsweise wabenartig mit Stegen 10 aufgebaut. Die Hohlräumen 4 besitzen vorzugsweise unterschiedliche Formen, um beispielsweise bei einer 7-Segment-Anzeige die Lage der Segmentfelder 9 vorteilhaft in das optische System der Leuchtflächen 7 einzutragen in Form von beispielsweise Brückenbändern zwischen Stegen 10. Wie Fig. 3 ferner zeigt, ist die Lage der lichtemittierenden Elemente 1 im jeweiligen Hohlraum 4 vorzugsweise so gewählt, dass das zugeordnete Segmentfeld 9 das lichtemittierende Element 1 zumindest teilweise überspannt. Die Hohlräume 4 können einen eckigen und/oder gerundeten Querschnitt besitzen.

Wie Fig. 1 und Fig. 2 zeigen, wird die Abschlussfläche 8 vorzugsweise über eine Diffusorplatte 11 abgedeckt. Der opake Rahmen 5 weist vorzugsweise eine wählbare Bauhöhe auf zur Überbrückung eines Abstandes zwischen der Leiterplatte 3 und einer Montagefrontwand (nicht dargestellt). Durch die Ausbildung der Hohlräume 4 und die Lagepositionierung der Segmentfelder 9 ist die Bauhöhe des Rahmens 5 individuell anpassbar, ohne dass die Lichtleitereigenschaften der Hohlräume 4 eine auf die Ausleuchtung der Segmentfelder 9 merkbare Auswirkung haben.

Das lichtemittierende Element 1 ist vorzugsweise jeweils als LED ausgebildet. Der Rahmen 5 kann mit seiner Unterseite unmittelbar auf der Oberfläche der Leiterplatte 3 aufliegen.

## Patentansprüche

1. Anzeigeeinrichtung zum Anzeigen von Informationen mit einer Mehrzahl von lichtemittierenden Elementen (1), die zueinander benachbart auf einem Anzeigenfeld (2) einer Leiterplatte (3) angeordnet und individuell ansteuerbar sind, wobei den lichtemittierenden Elementen (1) jeweils ein Hohlraum (4) zur Formgebung der von den lichtemittierenden Elementen (1) ausgesendeten Lichtstrahlen zur Erzeugung jeweils einer vergrößerten effektiven Leuchtfläche (7) in einem opakem Rahmen (5) zugeordnet ist, **dadurch gekennzeichnet, dass** die Hohlräume (4) der lichtemittierenden Elemente (1) ein flächig angeordnetes Hohlraumgefüge (6) bilden, deren effektive Leuchtflächen (7) abgedeckt sind durch eine lichtdichte Abschlussfläche (8) mit lichtdurchlässigen Segmentfeldern (9), die jeweils einen Teilbereich der Leuchtfläche (7) eines Hohlraums (4) des Hohlraumgefüges (6) als beleuchtbaren Leuchtflächenausschnitt bestimmen.

2. Anzeigeeinrichtung nach Anspruch 1, **dadurch gekennzeichnet, dass** das Hohlraumgefüge (6) wabenartig mit Stegen (10) aufgebaut ist zu Hohlräumen (4) unterschiedlicher Form.

3. Anzeigeeinrichtung nach Anspruch 1 oder 2, **dadurch gekennzeichnet, dass** die Hohlräume (4) einen eckigen und/oder gerundeten Querschnitt besitzen.

4. Anzeigeeinrichtung nach einem der Ansprüchen 1 bis 3, **dadurch gekennzeichnet, dass** das jeweilige Segmentfeld (9) das lichtemittierende Element (1) zumindest teilweise überspannt.

5. Anzeigeeinrichtung nach einem der Ansprüche 1 bis 4, **dadurch gekennzeichnet, dass** eine Diffusorplatte (11) die Abschlussfläche (8) abdeckt.

6. Anzeigeeinrichtung nach einem der Ansprüche 1 bis 5, **dadurch gekennzeichnet, dass** der Rahmen (5) eine wählbare Bauhöhe aufweist zur Überbrückung eines Abstandes zwischen der Leiterplatte (3) und einer Montagefrontwand.

7. Anzeigeeinrichtung nach einem der Ansprüche 1 bis 6, **dadurch gekennzeichnet, dass** das lichtemittierende Element (1) jeweils als LED ausgebildet ist.

8. Anzeigeeinrichtung nach einem der Ansprüche 1 bis 7, **dadurch gekennzeichnet, dass** der Rahmen (5) mit seiner Unterseite unmittelbar auf der Oberfläche der Leiterplatte (3) aufliegt.
